(19) Europäisches Patentamt

European Patent Office

Office européen des brevets

(11) **EP 0 788 210 B1**

(12) **FASCICULE DE BREVET EUROPEEN**

(45) Date de publication et mention
de la délivrance du brevet:
**27.03.2002 Bulletin 2002/13**

(51) Int Cl.⁷: **H02H 7/08**

(21) Numéro de dépôt: **97400077.0**

(22) Date de dépôt: **15.01.1997**

(54) **Relais électronique**

Elektronisches Relais

Electronic relay

(84) Etats contractants désignés:
**BE DE ES FR GB IT SE**

(30) Priorité: **02.02.1996 FR 9601466**

(43) Date de publication de la demande:
**06.08.1997 Bulletin 1997/32**

(73) Titulaire: **Schneider Electric Industries SA
92500 Rueil-Malmaison (FR)**

(72) Inventeur: **Romillon, Jean-Marc
78980 Longnes (FR)**

(74) Mandataire: **Saint Martin, René
Schneider Electric Industries SA,
Service Propriété Industrielle,
89, boulevard Franklin Roosevelt
92500 Rueil Malmaison (FR)**

(56) Documents cités:
**DE-A- 3 900 179          DE-A- 4 230 703
FR-A- 2 663 473**

## Description

La présente invention concerne un relais électronique de protection d'une charge électrique polyphasée.

Un relais électronique permet de protéger des moteurs polyphasés en coupant l'alimentation de ceux-ci lorsqu'il se produit par exemple, une surcharge de courant sur au moins une phase du moteur ou un déséquilibre entre les courants de phase. Ce type de relais comporte pour chaque phase de la charge un organe capteur de courant tel qu'un transformateur d'intensité délivrant un signal image de l'intensité du courant dans la phase. Il comporte aussi un circuit électronique de traitement qui reçoit et traite les signaux fournis par les organes capteurs pour délivrer un signal de déclenchement. Le relais peut par ailleurs comprendre des entrées logiques qui sont utilisées pour réaliser des fonctions de commande du moteur, telles que la fonction marche/arrêt, ou pour réaliser le réarmement du relais.

Il faut parfois contrôler la tension d'alimentation du moteur de manière à détecter les baisses de tension sur son alimentation. Il faut aussi contrôler le facteur de puissance du moteur, appelé communément cosφ, où φ est l'angle entre la tension et le courant du moteur afin de détecter la marche à vide du moteur. Les valeurs du courant, de la tension d'alimentation du moteur et du facteur de puissance sont par ailleurs nécessaires pour calculer la puissance absorbée par le moteur.

On estime l'angle φ entre la tension et le courant du moteur en comparant le signal de courant dans une phase du moteur délivré via un transformateur de courant avec le signal de tension du moteur délivré via un capteur de tension de type transformateur de tension. *Dans le document FR A 2663473, il est par ailleurs décrit un dispositif et un procédé de limitation de charge pour moteur électrique dans lequel l'angle φ entre la tension et le courant du moteur est calculé en prenant une valeur de tension continue image de la tension d'alimentation du moteur.* Or, ce*s* procédé*s* de calcul engendre*nt* comme inconvénient un besoin de moyens spécifiques de mise en oeuvre puisqu'il est nécessaire *de disposer d'une entrée analogique supplémentaire sur le circuit électronique de traitement pour lire une tension et/ou* d'ajouter des transformateurs de tension et de prévoir des connexions supplémentaires internes dans le relais.

L'invention vise par conséquent, de manière simple et à faible coût, le calcul du facteur de puissance du moteur et de la tension d'alimentation du moteur à partir des moyens connus nécessités pour réaliser la fonction de protection du relais sans avoir besoin d'ajouter des moyens spécifiques.

A cet effet, l'invention a pour objet un relais électronique de protection d'une charge électrique polyphasée telle qu'un moteur comprenant un organe capteur par phase pour délivrer un signal dépendant de l'intensité du courant de phase, des entrées logiques recevant des signaux extérieurs et un circuit électronique à microcontrôleur destiné à traiter les signaux fournis d'une part par les organes capteurs, et d'autre part par les entrées logiques, caractérisé en ce qu'un signal de tension, image de la tension d'alimentation du moteur, est appliqué à une des entrées logiques associée à un circuit délivrant un signal redressé de tension, *constitué de simples alternances carrées entre un minimum de tension et un maximum de tension* et que le circuit électronique comprend des moyens de traitement pour calculer, à partir du signal de courant délivré par l'organe capteur de courant et des caractéristiques rattachées à la période du signal redressé de tension délivré par le circuit associé à l'entrée logique, la valeur du facteur de puissance du moteur et/ou la valeur de la tension d'alimentation du moteur.

Selon une caractéristique, les moyens de traitement du circuit électronique estiment notamment la période du signal redressé de tension et le temps pendant lequel le signal redressé de tension présente un état minimal de tension pour calculer le déphasage entre le courant et la tension. Le déphasage estimé est avantageusement comparé à une table de valeurs interne au circuit électronique et définissant une correspondance entre des valeurs de déphasage et des valeurs associées de cosinus.

La description faite ci-après en regard des dessins fera ressortir les caractéristiques et avantages de l'invention. Aux dessins annexés:

-    la figure 1 est un schéma du relais de protection selon l'invention;

-    la figure 2 est un diagramme relatif à la tension d'alimentation du moteur et au courant consommé par celui-ci.

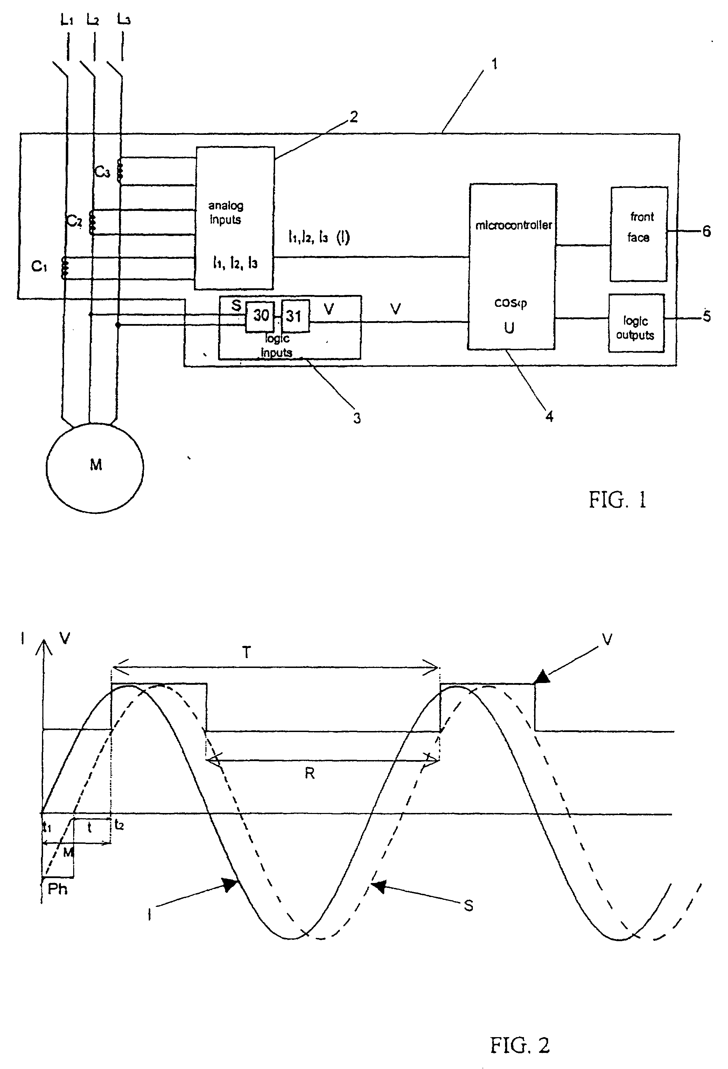

Le relais électronique 1, illustré à la figure 1, est destiné à être associé à une charge électrique polyphasée telle qu'un moteur triphasé M alimenté par une ligne L1, L2, L3. Le relais comprend des capteurs de courant de type transformateurs d'intensité repérés C1, C2 et C3 disposés respectivement sur les fils de phase L1, L2, et L3. Ces transformateurs sont des capteurs connus et habituellement utilisés pour les mesures de courant.

Le relais présente d'une part, des entrées analogiques 2 qui reçoivent les signaux alternatifs I1, I2, et I3 des courants de phase délivrés par les transformateurs C1, C2 et C3, et d'autre part, des entrées logiques 3. Une des entrées logiques 30 reçoit un signal alternatif S représentatif de la tension d'alimentation du moteur prélevée sur deux fils de phase.

Le circuit électronique 4 comprend des moyens de traitement aptes à calculer à partir des informations reçues, pour chacune des phases L1, L2 et L3, le déphasage φ du signal I1, I2, I3 correspondant avec le signal V. Dans l'hypothèse où le moteur est une charge équilibrée, le calcul du déphasage φ pourra être fait sur une seule phase uniquement.

La figure 2 représente le signal alternatif sinusoïdal de courant I d'une phase de la ligne tel que le signal I1 et le signal redressé carré V du signal alternatif de tension S illustré en pointillés. Le signal de tension V est constitué par de simples alternances carrées passant périodiquement d'un minimum de tension, qu'on nommera l'état 0, à un maximum de tension, qu'on nommera l'état 1. Les signaux permettent de déterminer le décalage Ph du courant sur la tension.

Un mode de calcul du déphasage φ et de la tension absorbée est donné à titre d'exemple ci-après.

Les moyens de traitement du circuit 4 estime à partir du signal de courant I et du signal de tension V, la période T du signal de tension V, le temps R durant lequel le signal de tension V est à l'état 0 et le temps M s'écoulant entre l'instant t1 pour lequel le signal de courant I passe par le zéro d'intensité et l'instant t2 pour lequel le signal de tension V passe de l'état 0 à l'état 1.

En se référant à la figure 2, le décalage Ph s'exprime par:

$$Ph = M - t,$$

où t est le temps s'écoulant entre l'instant de passage par zéro du signal de tension S et l'instant de passage du signal redressé de tension V de l'état 0 à l'état 1.

Le temps t est calculé à partir des valeurs T et R estimées selon la formule suivante:

$$2 \times t = (T/2) - (T - R) \text{ qui s'écrit encore } t = \frac{2R - T}{4}.$$

Ainsi le décalage Ph s'exprime par:

$$Ph = M - t = M - \frac{2R - T}{4}.$$

Le décalage Ph représente un déphasage φ qui, s'exprimant en degré, s'écrit alors:

$$\varphi = \left(\frac{Ph}{T/4}\right) \times 90.$$

Le déphasage φ estimé est comparé avec des valeurs de déphasage en degrés enregistrées dans une table interne au circuit 4 définissant une correspondance entre les valeurs de déphasage et les valeurs associées de cosinus.

La valeur d'angle la plus proche de φ sert à déterminer le cosinus φ ou la valeur du facteur de puissance du moteur, correspondant au déphasage entre la tension alimentant le moteur et le courant consommé par celui-ci.

Le circuit électronique 4 est aussi apte à calculer la valeur de la tension d'alimentation U du moteur. Les moyens de traitement du circuit 4 calculent un coefficient de tension K qui dépend de la période T et du temps R du signal de tension V.

Le coefficient K est représentatif de l'amplitude du signal de tension et augmente avec celle-ci. A titre indicatif, ce coefficient K peut être calculé par $K = \frac{R - T}{T}$.

La valeur de la tension U est par exemple déterminée en comparant la valeur estimée du coefficient K avec des valeurs de coefficient enregistrées dans une table interne au circuit 4 définissant une correspondance entre des valeurs de coefficient et des valeurs associées de tension.

En variante, la tension d'alimentation U pourrait être calculée d'une autre façon. Pour une échelle de valeurs de tension allant, de préférence, de 100 Volts à 250 Volts, la tension U s'écrit en fonction du coefficient directeur K sous la forme de l'équation affine suivante:

$$U = A + (B \times K),$$ où A et B sont des constantes préenregistrées dans le circuit.

La tension U peut alors être calculée à partir de cette équation en remplaçant dans celle-ci la valeur du coefficient K estimé par les moyens de traitement du circuit 4.

Les valeurs du facteur de puissance cos φ et de la tension d'alimentation U sont destinées à être comparées à des valeurs de seuil préétablies en-dessous desquelles le circuit électronique 4 est apte à donner un ordre de déclenchement à des sorties logiques 5 pour arrêter par exemple le moteur et à transmettre des informations relatives au facteur de puissance et à la tension d'alimentation à un automatisme ou à un composant de visualisation 6 disposé sur la face avant du relais.

L'invention permet donc d'utiliser les entrées logiques du relais pour le calcul des valeurs du facteur de puissance et de la tension d'alimentation à partir des caractéristiques rattachées à la période d'un signal, image de la tension d'alimentation, sans avoir besoin de transformateurs de mesure de tension. En outre, il est à remarquer que le calcul de la valeur de tension est effectué sans avoir besoin de connaître la fréquence du signal de la tension d'alimentation égale généralement à 50 ou 60 Hz.

## Revendications

1. Relais électronique de protection d'une charge électrique polyphasée telle qu'un moteur comprenant un organe capteur (C1, C2, C3) par phase pour délivrer un signal (I) dépendant de l'intensité du courant de phase, des entrées logiques (3) recevant des signaux extérieurs et un circuit électronique à microcontrôleur (4) destiné à traiter les signaux fournis d'une part par les organes capteurs, et d'autre part par les entrées logiques, **caractérisé en ce qu'**un signal de tension (S) image de la tension d'alimentation du moteur est appliqué à une des entrées logiques (3) associée à un circuit (31) délivrant un signal redressé de tension (V), *constitué de simples alternances carrées entre un minimum de tension et un maximum de tension* et que le circuit électronique (4) comprend des moyens de traitement pour calculer, à partir du signal de courant (i) délivré par l'organe capteur de courant et des caractéristiques rattachées à la période (T) du signal redressé de tension (V) délivré par le circuit (31), la valeur du facteur de puissance du moteur (cosφ) et/ou la valeur de la tension d'alimentation (U) du moteur.

2. Relais électronique selon la revendication 1, **caractérisé en ce que** les moyens de traitement du circuit électronique (4) estiment la période (T) du signal redressé de tension (V) et le temps (R) pendant lequel le signal de tension (V) présente un état minimal de tension.

3. Relais électronique selon la revendication 2, **caractérisé en ce que** les moyens de traitement du circuit électronique (4) estiment le temps (M) s'écoulant entre l'instant (t1) pour lequel le signal de courant (1) passe par une intensité nulle et l'instant (t2) pour lequel le signal redressé de tension (V) passe d'un état minimal de tension à un état maximal de tension et calcule à partir de la valeur du temps (M), de la période (T) et du temps (R) le déphasage (φ) entre le signal de courant (I) et le signal de tension (S).

4. Relais électronique selon l'une quelconque des revendications précédentes, **caractérisé en ce que** le facteur de puissance (cosφ) est estimé à partir du calcul du déphasage (φ) entre le signal de courant (I) et le *signal redressé de tension (V)* et à partir d'une table définissant une correspondance entre des valeurs de déphasage et les valeurs associées de cosinus.

5. Relais électronique selon l'une quelconque des revendications 2 à 4, **caractérisé en ce que** les moyens de traitement du circuit électronique (4) calculent un coefficient de tension (K) qui dépend de la période (T) et du temps (R) du signal redressé de tension (V) de manière à estimer la valeur de la tension d'alimentation (U) du moteur.

6. Relais électronique selon la revendication 5, **caractérisé en ce que** la valeur de la tension d'alimentation (U) est estimée à partir d'une table de valeurs définissant une correspondance entre des valeurs de coefficient de tension et les valeurs associées de tension.

7. Relais électronique selon la revendication 5, **carac-**

**térisé en ce que** la tension d'alimentation (U) s'écrit sous la forme de l'équation d'une fonction affine dont le coefficient directeur est égal au coefficient de tension (K).

## Claims

1. An electronic protective relay for a multiphase electric load such as a motor that includes one sensor device (C1, C2, C3) per phase to supply a signal (I) that depends on the intensity of the phase current, logic inputs (3) receiving external signals and an electronic microcontroller circuit (4) for processing the signals supplied, on the one hand by the sensor devices and, on the other hand by the logic inputs, **characterised in that** a voltage signal (S), an image of the supply voltage to the motor, is applied to one of the logic inputs (3) linked to a circuit (31) supplying a rectified voltage signal (V) and that the electronic circuit (4) includes processing means to calculate, from the current signal (I) supplied by the current sensor device and characteristics linked to the period (T) of the rectified voltage signal (V), made up with simple squared rotations between a minimum voltage and a maximum voltage, and that the electronic circuit (4) includes processing means to calculate, from the current signal (1) issued from the current sensor device and specifications connected to the time (T) of the rectified voltage signal (V) supplied by the circuit (31), the value of the power factor of the motor (cosφ) and/or the value of the power supply voltage (U) to the motor.

2. An electronic relay according to Claim 1, **characterised in that** the processing means of the electronic circuit (4) assesses the period (T) of the rectified voltage signal (V) and the time (R) during which the voltage signal (V) is in its minimum voltage condition.

3. An electronic relay according to Claim 2, **characterised in that** the processing means of the electronic circuit (4) assesses the time (M) passing between the instant (t1) at which the current signal (I) passes through zero intensity and the instant (t2) at which the rectified voltage signal (V) passes from minimum to maximum voltage condition and calculates, from the value of the time (M), the period (T) and the time (R), the phase shift (φ) between the current signal (I) and the voltage signal (S).

4. An electronic relay according to claim 3, **characterised in that** the power factor (cosφ) is assessed from the calculation of the phase shift (φ) between the current signal (I) and the rectified voltage signal (V) and from a table defining a correlation between phase shift values and the associated cosine values.

5. An electronic relay according to Claim 2, **characterised in that** the processing means of the electronic circuit (4) calculates a voltage coefficient (K) that is dependent on the period (T) and the time (R) of the rectified voltage signal (V) so as to assess the value of the power supply voltage (U) of the motor.

6. An electronic relay according to Claim 5, **characterised in that** the value of the power supply voltage (U) is assessed from a table of values defining a correlation between voltage coefficient values and the associated voltage values.

7. An electronic relay according to Claim 5, **characterised in that** the power supply voltage (U) is written in the form of the refining function equation whose director coefficient is equal to the voltage coefficient (K).

**Patentansprüche**

1. Elektronisches Relais als Schutz einer mehrphasigen Strombelastung wie zum Beispiel ein Motor mit einem Meßfühler (C1, C2, C3) pro Phase, um ein Signal (I) zu liefern, das von der Stromintensität der Phase abhängig ist, logische Eingänge (3), die äußere Signale empfangen und ein elektronischer Kreis mit Mikrobaustein (4), der dafür vorgesehen ist, die einerseits von den Meßfühlern und andererseits von den logischen Eingängen gelieferten Signale zu verarbeiten, **dadurch gekennzeichnet, daß** ein Spannungssignal (S) als Abbild der Speisespannung des Motors, an einen logischen Eingang (3) angewandt wird, der mit einem Kreis (31) verbunden ist, welcher ein gleichgerichtetes Spannungssignal (V) liefert, bestehend aus einfachen, quadratischen Wechselfolgen zwischen einer Mindestspannung und einer Höchstspannung und daß der elektronische Kreis (4) Verarbeitungsmittel enthält, um ausgehend vom Stromsignal (I), das vom Strommeßfühler geliefert wird, sowie von Merkmalen, die mit dem Zeitintervall (T) des gleichgerichteten Spannungssignal (V) verbunden sind, das vom Kreis (31) geliefert wird, dem Wert des Leistungsfaktors des Motors (cosφ) und/oder dem Wert des Speisestroms (U) des Motors aus, zu berechnen.

2. Elektronisches Relais nach Patentanspruch 1, **dadurch gekennzeichnet, daß** die Verarbeitungsmittel des elektronischen Kreises (4) das Zeitintervall (T) des gleichgerichteten Spannungssignals (V) bewerten und die Zeit (R), während welcher das Spannungssignal (V) einen Zustand der Mindestspannung darstellt.

3. Elektronisches Relais nach Patentanspruch 2, **dadurch gekennzeichnet, daß** die Verarbeitungsmittel des elektronischen Kreises (4) die Zeit (M) bewerten; die zwischen dem Moment (t1) für welchen das Stromsignal (I) durch eine Nullintensität geht und dem Zeitpunkt (t2) für welchen das gleichgerichtete Spannungssignal (V) von einem Zustand der Mindestspannung auf einen Zustand der Höchstspannung übergeht, und vom Wert der Zeit (M), dem Zeitintervall (T) und der Zeit (R) aus den Phasenverlust (φ) zwischen dem Stromsignal (I) und dem Spannungssignal (S) berechnet.

4. Elektronisches Relais nach einem der vorstehenden Patentansprüche, **dadurch gekennzeichnet, daß** der Leistungsfaktor (cosφ) von einer Berechnung der Phasenverschiebung (φ) zwischen dem Stromsignal (I) und dem gleichgerichteten Spannungssignal (V) aus bewertet wird, sowie von einer Tabelle, die eine Beziehung zwischen den Werten der Phasenverschiebung und den verbundenen Werten des Kosinus definiert.

5. Elektronisches Relais nach einem der Patentansprüche 2 bis 4, **dadurch gekennzeichnet, daß** die Verarbeitungsmittel des elektronischen Kreises (4) einen Koeffizienten der Spannung (K) berechnen, der vom Zeitintervall (T) und der Zeit (R) des gleichgerichteten Spannungssignals (V) abhängt, um den Wert der Speisespannung (U) des Motors zu bestimmen.

6. Elektronisches Relais nach Patentanspruch 5, **dadurch gekennzeichnet, daß** der Wert der Speisespannung (U) von einer Tabelle von Werten aus bestimmt wird, die eine Beziehung zwischen den Werten des Koeffizienten der Spannung und den verbundenen Werten der Spannung definieren.

7. Elektronisches Relais nach Patentanspruch 5, **dadurch gekennzeichnet, daß** die Speisespannung (U) sich in Form einer Gleichung mit einer genauer formulierten Funktion geschrieben wird, dessen richtungsweisender Koeffizient gleich dem Koeffizienten der Spannung (K) ist.

FIG. 1

FIG. 2